Europäisches Patentamt

European Patent Office

Office européen des brevets

(11) Publication number: **0 313 230**
**A2**

# (12) EUROPEAN PATENT APPLICATION

(21) Application number: 88309101.9

(22) Date of filing: 30.09.88

(51) Int. Cl.⁴: **G06F 11/26 , G01R 31/28**

(30) Priority: 23.10.87 US 112920

(43) Date of publication of application:
26.04.89 Bulletin 89/17

(84) Designated Contracting States:
**DE FR GB**

(71) Applicant: **CONTROL DATA CORPORATION**
**8100-34th Avenue South**
**Minneapolis Minnesota 55440(US)**

(72) Inventor: **Teske, Judy Lynn**
**12514 Parkwood Drive**
**Burnsville Minnesota 55337(US)**
Inventor: **Baxter, Daniel James**
**861 Dealton Street**
**St. Paul Minnesota 55166(US)**
Inventor: **Daane, Don Adrian**
**701 East 132 nd Street**
**Burnsville Minnesota, 55337(US)**
Inventor: **Borchers, Brian Dale**
**1500 134th Street East, 4**
**Burnsville Minnesota 55337(US)**
Inventor: **Allen, David Howard**
**1749 Hickory Hill**
**Eagan Minnesota 55122(US)**
Inventor: **Maas, Michael Francis**
**2668 Midvale Place**
**Maplewood Minnesota 55119(US)**

(74) Representative: **Caro, William Egerton et al**
**J. MILLER & CO. Lincoln House 296-302 High**
**Holborn**
**London WC1V 7JH(GB)**

(54) VLSI chip with test circuitry.

(57) A VLSI chip has a core logic area surrounded by a peripheral zone including a plurality of I/O cells (10) through which nearly all signals between the pins and the core logic (CLI, CLO) pass. Each cell has an input buffer (IB) and an output buffer (OB) through which signals pass respectively from pin to core logic and vice versa, and a control register controlling the operation of the I/O cells. Two shift registers, an input register and an output register, are formed by flip-flops also included in the I/O cells and connected to the buffers, core logic, and pins, and to test data in and out registers and pins. Some of the I/O cells may be dummy cells forming part of the input and/or output registers but not having pins.

Timing circuitry (MS1, MS2; 52, 53) provides early signals (TST EARLY, TCE EARLY) to set up predetermined flip-flops prior to their receiving clocked signals (TST COPY, TCE COPY), and for separating a system clock input (CLK0) as a first clock signal (CLK1) to the control circuitry and a second clock signal (CLK2) to the input and output registers to allow the control register to operate without clocking the input or output registers.

## VLSI Chip with Test Circuitry

This invention relates to improvements in VLSI (very large scale integration) testability and standardised chip design.

Testability is a feature of VLSI circuit design which enhances the ability of the chip manufacturer, the original equipment manufacturer who installs the chips on a circuit board, and the end user to determine the adequacy of a particular piece of integrated circuit to perform the task it was designed for. Testability affects several aspects of VLSI chips, including performance characteristics such as speed and consistency of throughput, consistency of throughput in the face of changing environmental conditions, correct performance of particular logic gates and combinational logic structures, correctness of the physical design in terms of whether and how true it is to the logical design characteristics specified, etc. The enhancements and features described herein work together as a system to provide improvements in testability and, at the same time, provide for more efficient use of available semi-conductor area ("silicon real estate"). Testability at the chip level can support module, board or system level testability.

Different varieties of test systems have been built into Large Scale Integrated (LSI) and VLSI circuit chips to improve testability. One particular example, shown in U.S. Patent no 4 660 198 (Lyon), is designed specifically for detecting data errors at the earliest point that an error occurs in a combinational logic processing stream. This finds the errant logic by capturing data output from any point in the processing stream based on the first error found.

A different scheme for building testability into chips is described in U.S. Patent no 4 357 703 (van Brunt). This contemplates the use of a control register for controlling transmission gates, an operand generator and accumulator, and an output generator and accumulator, in order to control the input to the main function under test and direct its output for analysis. Test data is fed in through the control shift register and the test is controlled through the test control input.

As chips become more complicated and larger, it becomes helpful to include things like specialised flip-flops for holding test operands as they progress through complicated internal logic segments deep within the chip. Such a system is described in U.S. Patent Application Serial No. 046,218.

Scan testing of various kinds besides those described herein can be used in conjuction with the present system, and can easily be implemented without consuming additional I/O pins. For a discussion on scan designs see "Testing Semi-Custom Logic", McClusky, Semi-Conductor International, September 1985, pages 118-123, and "Built In Self Test Techniques", McClusky, April 1985, IEEE Design and Test, pages 21-36. Some of these and other design features and considerations for testability are described in "A Fast 20K Gate Array With On-Chip Test System", Ron Lake, VLSI System Design, June 1986; "Checking Out VLSI With Standard Test Gear", David R. Resnick, Electronics, 26 May 1986; and "Testability and Maintainability With A New 6K Gate Array", David Resnick, VLSI Design, March/April 1983. The information contained in these articles is incorporated herein by this reference.

As the number of gates in a VLSI chip goes up and as they become more and more application-specific in design, the need for simple, consistent testability characteristics becomes more and more important. Along with testing for the correctness of logic, process characteristics which affect performance (such as variations in capacitance and resistance) can and should also be tested for.

The general object of the present invention is therefore to provide a VLSI chip in which implementation and testing of the desired functions can be achieved more readily.

Accordingly the present invention provides a VLSI chip comprising a large number of pins and a core logic area, characterised by a peripheral zone including: a plurality of I/O cells through which nearly all signals between the pins and the core logic pass, each cell comprising an input buffer and an output buffer through which signals pass respectively from pin to core logic and vice versa; and control circuitry controlling the operation of the I/O cells.

In the preferred arrangement, two shift registers, an input register and an output register, are formed by flip-flops also included in the I/O cells and connected to the buffers, core logic, and pins, and to test data in and out registers and pins; these registers are particularly intended for use in testing the operation of the chip. Some of the I/O cells may be dummy cells forming part of the input and/or output registers but not having pins. Timing circuitry provides early signals to set up predetermined flip-flops prior to their receiving clocked signals, and for separating a system clock input as a first clock signal to the control circuitry and a second clock signal to the input and output registers to allow the control register to operate without clocking the input or output registers.

The present arrangement is concerned primarily with providing improvements in the testability of VLSI circuits. All of the components of the arrangement work together to provide improved performance, enhanced flexibility, and added features. These components include: a ring oscillator distributed around the periphery of the VLSI chip for measuring performance characteristics; a unit I/O cell design connected to each signal pin and located around the periphery from which are built the serially connected input register (IR) and output register (OR); extra register flip-flops (some of which are "dummy" or "filler" flip-flops for increasing the length of a register, and some of which are Control Register flip-flops) provided in a serial path; the input register and output register being serially linked and forming a boundary scan test structure; and clock signals being provided to the IR and/or OR and being de-coupled from the control register's clock. Test Strobe (TST) and Test Clock Enable (TCE) inputs to the chip are also provided in latched and early forms for enhanced functionality. Measurement of clock skew may be made from within the user customisable central logic area (also called the core logic area) by using a clock monitor pin. An optimised operand generation scheme for the input register is described. A new check-sum generation scheme for the output register is explained. The use of a control register to control on-chip test and maintenance functions is also described.

These features of the present arrangement are useful not merely to enhance testability but to do so in such a way that a limited amount of silicon real estate is employed. The design of such chips is made easier by ensuring that the testability is taken care of, in a manner which is unchanging from one ASIC (Application Specific Integrated Circuit) to another, before user customisable design is begun. The design and features of the logic in the ASIC portion are subject to change at the whim of the designer, and such changes are not related to the present invention.

A big factor in this designing for testability is the provision of I/O cells at substantially every pin around the periphery of the chip. Not all of these pins are employed by the input register/output register and control register. A certain number of them, depending on the number of pins required by the application that the chip is being designed for and the requirements of the input register/output register and control register, are used to satisfy the testability requirements of that application. In such cases, more or fewer I/O cells will be available for direct output from and input to the core logic area on the chip. The core logic is generally not contained physically in the chip periphery, whereas most of the circuitry discussed in detail herein is located there. Output from the output buffer may be had in a serial stream through the test data output pin or it may be received in a parallel manner from the output register through the output register pins.

A scan path testing design other than that described herein may also be easily used in conjunction with the other features described herein, without consuming additional I/O pins.

The term "flip-flop" is used generally herein for static or dynamic flip-flops or latches of various kinds as desired in the light of design requirements.

The present patent application is primarily directed to only some of the features of the present system. Three further patent applications of the same applicants are being filed simultaneously herewith, "Check Sum Circuitry for VLSI Chip" (Appendix A), "VLSI Chip with Ring Oscillator" (Appendix B), and "Clock Distribution on VLSI Chip" (Appendix C). These are directed primarily to the remaining features of the present system; their descriptions are hereby incorporated in the present patent application by reference. The present arrangement may conveniently be constructed as an improved and extended implementation of the system described in the van Brunt patent cited above. That patent is concerned with providing on-chip test circuitry for what becomes in the present arrangement the core logic. The core logic circuitry is regarded as a large number of flip-flops interconnected by combinatorial logic circuits to perform some desired function. For testing purposes, certain additional circuitry is included, and the flip-flops individually include features which are arranged and interconnected in a manner which facilitate testing. The additional circuitry consists primarily of OCMS (onchip maintenance system) registers (a control register 28, an input test register 26 including a pseudo-random number generator, and an output test register 32 including check sum means). This additional circuitry may support other schemes for providing testability to the core logic, and van Brunt is used here in a heuristic sense only.

This van Brunt system can be operated in a number of modes. There is standard operation (logic analyser sequence), in which the circuitry performs its normal operation (designed function), which may be monitored by the OCMS. Available is a basic chip interconnect test sequence, in which the signals are passed from the input to the output buffer via the OCMS, bypassing the flip-flop and combinatorial logic circuitry. There are also available static and dynamic general chip test modes in which signals are passed through the flip-flop and combinatorial logic circuitry via the OCMS, bypassing the input and output buffers or employing them as part of the test path. There are available combinatorial logic test modes, like the general chip test modes but in which all the combinatorial logic is bypassed except that between two particular adjacent ranks (or between the input buffer and the first rank, or the last rank and the output buffer). There are available flip-flop forcing modes in which all the combinatorial logic coupling the flip-flops is bypassed, so that the flipflops can be forced to predetermined values, from the input buffer or the OCMS, in each chain, and the outputs of the chains monitored by the OCMS. There is even a serial scan mode, in which all the combinatorial logic is bypassed and the chains are all connected in sequence to form a single test path through all flip-flops. The use of these modes may be ordered to yield the most needed or effective test paths.

A VLSI chip incorporating the various features of the present arrangement will now be described, by way of example, with reference to the drawings, in which:

Figure 1 is a logic diagram illustrating an I/O cell of the chip;

Figure 2 is a logic diagram illustrating the control register of the chip and showing its association with various clock and test control signals; and

Figure 3 is a logic diagram showing a Test Data Out latch and its association with the output register.

## UNIT I/O CELL ORGANIZATION AND CHIP DESIGN OVERVIEW

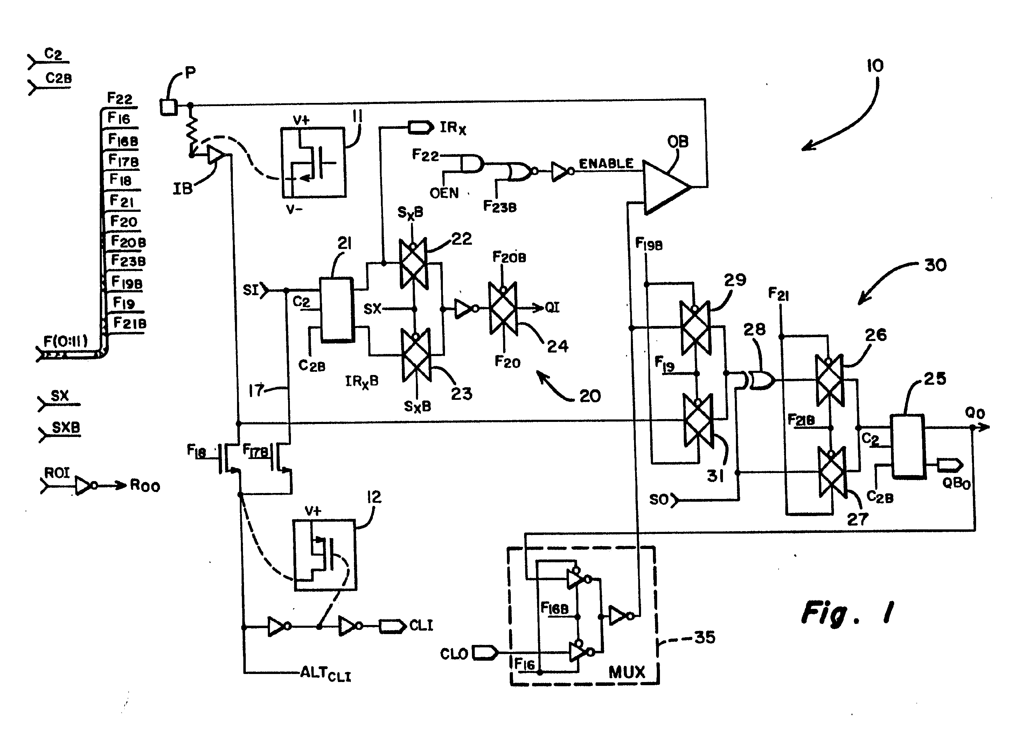

Referring to Figure 1, communication from the world outside the present chip with its innards is through pins such as pin P, each of which is associated with a standard input/output cell. These input/output cells (I/O cells) are major components of the test system, the Input Register (IR) and Output Register (OR) being built from them. The present chip is physically about 10.7 mm square and has roughly 20,000 user customisable gate equivalents. It has 240 unit I/O cells for attachment to pins and is configured to have 249 Input Register stages and 241 Output Register stages. A Control Register (CR) having 24 elements is also used; it is linked to the Test Data Input pin for its input. The CR is serially linked to the least significant or first stage of the IR.

All normal (non-test and non-maintenance) operational communication to the outside world goes through these unit I/O cells. System design is thus easier since all signal pins are capable of input and output, not just input or just output as in other systems where these limitations are cast in silicon before the designer of the Application Specific Integrated Circuit (ASIC) can begin his work.

The present chip also has 8 pins (called VISTA (VLSI Integrated Self Test Architecture) pins) dedicated to testing which do not use unit I/O cells. These are Test Clock Enable (TCE), Test Strobe (TST), system clock input (which after buffering is referred to as CLKO), Ring Oscillator Output (ROO), Ring Oscillator Enable (ROE), Clock Monitor (CKM), Test Data Input (TDI) and Test Data Output (TDO). The functions of these are explained later. Power and ground pins also do not use unit I/O cells. The present chip has 296 pins in total; 240 for signal pins, 8 for VISTA pins and 24 each for power and ground.

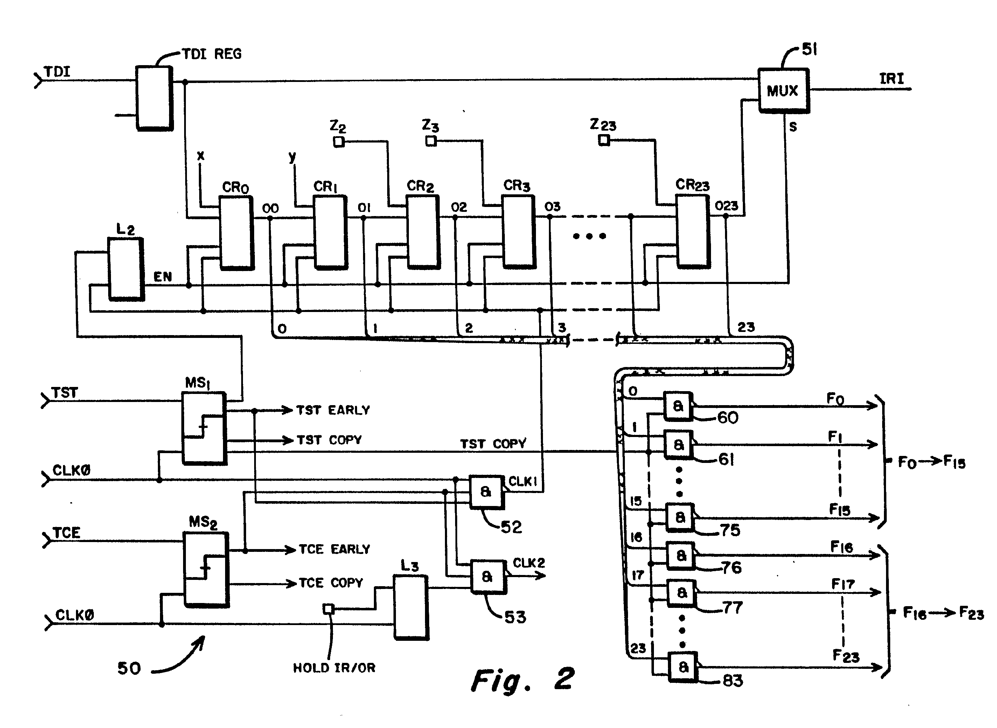

The I/O cell provides input to the core logic of the chip through the Core Logic In (CLI) output from the circuit 10 and accepts output from the core logic at the Core Logic Out (CLO) input point to the circuit 10. (The core logic is the ASIC which gives the chip its desired operational functions.) The input register element and output register element are shown as sub-units 10i and 10o of the circuit 10. The diagram shows primarily the logical arrangement of the I/O cell; inserts 11 and 12 show additional circuit elements which are required for its proper electrical functioning. The F inputs at the left side of Figure 1 are control signals which control the circuit 10 to perform its numerous functions. These signals are derived from outputs of the control register (CR), and will be explained with reference to Figure 2 below. In particular, to enable the Core Logic Output (CLO) to pass through the pin P, the signals F16 and F16B (the inverse of F16), F22 and F23B, and the output enable signal (OEN) must all co-operate. Likewise, to enable the input from P to arrive at the Core Logic In (CLI), F18 must be active.

Input SI stands for serial input, which is the output of the preceding input register stage. The circuit 20 may be considered an input register flip-flop having its information stored in flip-flop 21. The remainder of the circuit 20 following register element 21 operates as an XOR gate, allowing only IRX or SX to pass as the output signal at Q1. This XOR gate structure is used to implement an operand generation scheme described in detail in the associated patent application mentioned above, "Check Sum Circuitry for VLSI Chip". Signal SX and its inverse (complement) SXB are either feedback signals received from more significant Input Register IR stages or hardwired as SX-active/SXB-inactive, as required for the particular feedback polynomial. ("X" stands for the appropriate register stage number.) Some of the I/O cells may be dummy cells forming part of the input and/or output registers but not having pins, as is also explained in that patent application.

In Figure 1, signal lines designated with Q indicate output to the following element connected serially, and those designed with S generally indicate input from the preceding serially connected element. However, the SX designations do not follow this convention, being derived from a hardwired signal (always 1 or always 0) or a relatively distant following stage in the serially connected register.

The direct and complementary outputs IRX and IRXB of the flip-flop 21 go to transmission gates 22 and 23 respectively. These gates, and other gates shown similarly, are active (allowing the data input to proceed forward) when the upper (control) input is 0 (or negative) and the lower control input is 1 (or positive). The data input to gate 22 also may be provided to the on-chip logic as IRX. An inverted (complementary) output is provided at output Q1 after gate 24 as the serial input to the next input register stage.

The Output Register (OR) 30 is similarly configured. Again, off-chip output is available at pin P, from output buffer OB. If the ENABLE signal to output buffer OB is activated, then the output from circuit 35 will appear at pin P. If the pin's output is to be that of output register circuit 30, the QO output would be gated out by F16B. The flip-flop, or register element, is circuit 25 and the inverted output is also provided at QBO. F21 and F21B control gates 26 and 27, which provide the input to circuit 25. Under the control of F19 and F19B, one or other of the gates 29 and 31 will provide one input to XOR (exclusive OR) gate 28; the output S0 from the preceding output register element stage is the other input to XOR gate 28. XOR gate 28's output is fed to gate 26, and the SO input is fed to gate 27. F21 and F21B determine whether gate 26 or 27 is on.

It should be noted that an input on line 17 can be used as an input to circuit 21, depending on the configuration of signals F20B and F20 of gate 24 of the preceding stage. Signals F18 and F17B also must allow this transmission. Signal F18 also provides the ALTCLI and CLI inputs to the chip core logic with the information provided at P or with the information provided from the preceding QI output (input SI to the current I/O cell).

Thus by using a single cell for both input and output functions, this design achieves ease in layout, flexibility for different designs, the ability to have input and output registers with larger or smaller numbers of elements, and does not require the location of these registers to be predetermined. This design also avoids ground bounce and other analog problems.

## RING OSCILLATOR

The chip also includes a ring oscillator, one element of which is shown in Figure 1 as an inverter fed with signal ROI and producing signal ROO, because it is built out of an area which includes the I/O cell at the chip periphery. The ROE signal enables the ring oscillator. It provides an input which is available to the core but which does not use a unit I/O cell. The pin input also is available, in the preferred arrangement, to enable the scan mode of the registers used in scan mode and/or for other purposes. The ring oscillator is described in detail in the associated patent application referred to above, "VLSI Chip with Timing Test Circuitry".

## CONTROL REGISTER FUNCTION WITHOUT INPUT OR OUTPUT REGISTER FUNCTION

Figure 2 shows the 24-bit control register, flip-flops CR0 to CR23. These flip-flops each have four input lines; one from flip-flop L2, one from signal CLK1, and two data lines. Inputs x and y are hardwired 0 or 1 inputs and inputs z2 to z23 are hardwired in a chip identification sequence of 0's and 1's, which may be unique to each ASIC.

The enable (EN) input is a select line selecting either the hardwired input lines (x, y and z2 to z23) or the output of the flip-flop TDI register and the outputs of the previous control register stages as inputs to the flip-flops CR0 to CR23. The C2 input is the control register clock input. The outputs o0 to o22 are serially shifted into the next flip-flops (CR1-CR23) as input. Either the output from CR23 or the output from register TDI may be selected by the enable signal from L2. The flip-flops CR0-CR23 are called "muxed flip-flops", i.e. a multiplexer followed by a flip-flop. A reference to a flip-flop indicates the use of a data holding element, such as a latch, R-S flip-flop, etc.

The Input Register Input (IRI) signal is the output from either the TDI register or the most significant stage of the control register CR23. The IRI signal is available as input to the first stage of the input register.

At the first clock cycle after a check-sum operation (described in the patent application "Check Sum Circuitry for VLSI Chip" mentioned above) is complete, the data on x, y and z2 to z23 is clocked into the control register by the first clock of the shifting off operation, which serially shifts data out through the last stage of the output register and through the TDO output.

The test strobe enable signal TST is fed to a master-slave flip-flop MS1 from off chip and its inverse signal is passed through without clocking by the master part of this flip-flop MS1. The test clock enable signal TCE is fed to a master-slave flip-flop MS2 from off chip and its inverse signal is passed through without clocking by the master part of this flip-flop MS2. Both these TST and TCE "early" signals are fed to an AND gate 52. On the occurrence of a system clock pulse on CLK0, this gate 52 produces the control register clock CLK1, which clocks the control register flip-flops CR0 - CR23.

The TST and TCE early signals may be used for other purposes as well. For example, the receipt of these signals by the core logic prepares the core logic for the test mode in the preferred arrangement by initialising it all to a known state before receipt of the actual signals.

The other clock signal, CLK2, is produced by AND gate 53. This AND gate requires the system clock signal on CLK0 and the presence of the test clock enable TCE "early" signal but it also requires that the signal HOLD IR/OR not to be active at the input to hold latch L3 in order to produce a high signal as output.

The flip-flops of the input and output registers are also arranged serially, but the clock signal used for them is CLK2, not CLK1, which is supplied to the control register flip-flops. Thus, without the CLK2 signal, the input and output registers are not clocked and do not move in a serial fashion.

From the slave part of master slave flip-flop MS1, two copies of the TST signal are produced after the next occurrence of the system clock CLK0. One of these signals is one of the inputs to the NAND gates 60 to 83. These NAND gates require 1's, on their other inputs, from their associated control register flip-flops CR0- CR23 in order to produce active output and provide the F signals F0 - F23 seen on those lines in Figure 1. The use of these F signals can be seen along with their complements FxB in Figure 1. The control (F) signals from the control register are generated by NAND gates 60 - 83. In the preferred arrangement the F signals F0-F15 are user definable, and may be used to control any desired function on the ASIC. The remaining F signals perform predetermined functions.

F16 couples either the core logic out (CLO) signal or the output register output QO to the output buffer OB. F17B connects the input register input (or output from the previous stage through SI) to core logic at CLI. F18, F17B and F20/F20B work together to provide either a path for serial shift between input register stages (QI to SI), or a path from the pin P to the input register input (P to SI), or a path from the output of a previous stage (not shown) via the signal SI (shown in Figure 1) to core logic at CLI. Wherever the input register output QI is not connected to CLI, the pin input is. F19 allows the output buffer OB of Figure 1 to be included in the test path. The way this is done (see Figure 1) is to allow the output (which is usually from CLO) of the multiplexer 35 to go through the output buffer OB, appear at the pin P, and so appear back at gate 31.

F20 isolates each input register stage from the following stage by shutting down gate 24. F21 enables the check-summing operation in the output register, allowing the SO signal to be XORed with the output of gates 29 or 31. Stage 0 of the output register is not in an I/O cell and contains an XOR tree which is also activated on signal F21 to XOR the outputs from stages 2, 11 and the most significant stage, as described in detail in the patent application "Check Sum Circuitry for VLSI Chip" referred to above. F22 over-rides the OEN signal, shutting off the output buffers OB. F23 forces the output buffers OB on regardless of the output enable signal OEN, or the F22 signal.

## USE OF TEST STROBE EARLY AND TEST CLOCK ENABLE EARLY SIGNALS

Two advantages result from the use of these early signals. First, by having a separate signal path for special functions, the buffers do not need to be as large as would be necessary if no early signals were provided. Therefore there is less loading. Second, these early signals can be used to perform various functions where an initialisation of certain circuits is required, such as to set all storage elements of a certain type to a known valid logic level (1 or 0).

In the preferred arrangement, these early signals are taken from the master portion's output of the master-slave flip-flops MS1 and MS2 of Figure 2. In other words, the input signal appears at the output with no clock delay. Hence when these signals are brought to an initialisation input, a hardwired 1 or 0 can be forced into the flip-flops being initialised. At such a point, the initialised flip-flops can receive test data, the first datum to be received as test output being the chip identification hardwired into the control register, after the continuous string of either 0's or 1's from the initialisation step. This is the first use to which these early signals, test clock enable (TCE) early and test strobe (TST) early, are put in the preferred arrangement.

## SERIAL PATH REGISTRATION

Referring again to Figure 2, the TDI register clocks in a serial data stream into the control register, and this stream is serially clocked through the control register into the input register or may be clocked directly through IRI copy or IRI inputs into the input register. The test data input flip-flop TDI register is a clocked register, allowing less stringent timing requirements to be imposed on its input signal from off chip. The flip-flop TDI register allows the test data input to be clocked in, instead of having to be fed down the entire length of wire to the pin before getting into the control register or input register stages. This prevents the occurrence of timing problems which existed in previous arrangements.

## ENABLEMENT OF OUTPUT REGISTER PIN

In order to be able to output data from scan path flip-flops at any time through the test data output TDO (which normally is employed only during test mode to output the final flip-flop in the serial scan path), the final stage of the output register is fed together with control signals to a test data output flip-flop TDO register and continually provided at the test data output pin.

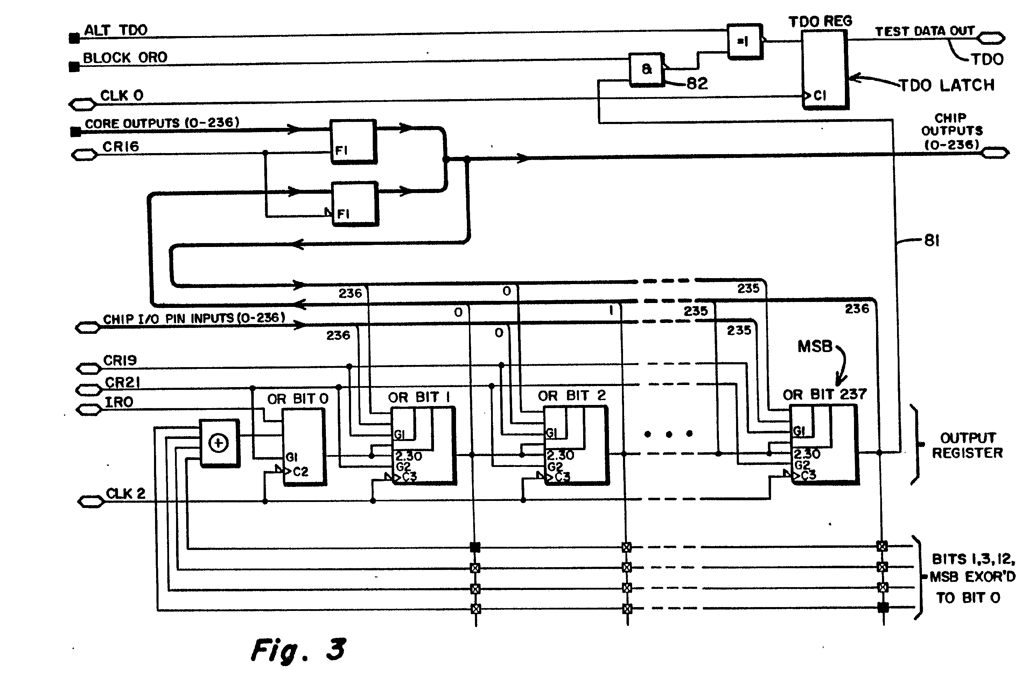

Figure 3 is a logic diagram of the 238 stage output register OR. The test data out TDO register is shown at the top of the diagram. The ALT TDO signal may be a copy of the test data output signal provided by the last register in the serial scan path, and may be provided from anywhere in the core logic. This may be especially useful for implementing other forms of scan path output, or XORing the scan path output with the outer register output. These registers are discussed earlier and are ordinarily located somewhere within the core logic or around the border. The BLOCK ORO line controls NAND gate 82 to block output from line 81 (from the most significant stage of the output register) from reaching the test data output register. The user configurable portion of the logic will determine the state of the BLOCK ORO line.

## Claims

1. A VLSI chip comprising a large number of pins (P) and a core logic area, characterised by a peripheral zone including: a plurality of I/O cells (10) through which nearly all signals between the pins and the core logic (CLI, CLO) pass, each cell comprising an input buffer (IB) and an output buffer (OB) through which signals pass respectively from pin to core logic and vice versa; and control circuitry (register CR, Fig. 2) controlling the operation of the I/O cells.

2. A VLSI chip according to claim 1, characterised in that the control circuitry comprises a control register (CR) having only one data input (TDI) from a pin.

3. A VLSI chip according to either previous claim, characterised in that in each I/O cell the output buffer is also fed from an output register flip-flop (20) included in the cell.

4. A VLSI chip according to any previous claim, characterised in that in each I/O cell the input buffer also feeds an input register flip-flop (30) included in the cell.

5. A VLSI chip according to claim 4, characterised in that the core logic is also fed by the input register flip-flop (via OB and IB).

6. A VLSI chip according to any one of claims 3 to 5, characterised in that the input and/or output register flip-flops of a plurality of adjacent I/O cells are coupled together (QI to SI, QO to SO) to form multi-stage shift registers.

7. A VLSI chip according to claim 6, characterised in that the connections between successive stages of the input and/or output registers include XOR circuits (22,23) also fed from the core logic.

8. A VLSI chip according to either of claims 6 and 7, characterised in that the final stage of the input and/or output registers are connected back to the first stage to form a ring.

9. A VLSI chip according to any one of claims 6 to 8, characterised in that some of the I/O cells are dummy cells forming part of the input and/or output registers but not having pins.

10. A VLSI chip according to claims 4 or 5 and any one of claims 6 to 9, characterised by a Test Data Input register (TDI REG) for providing serial input data to the core logic and fed from a pin which also feeds the input register.

11. A VLSI chip according to claim 3 and any one of claims 6 to 10, characterised by a Test Data Output register (TDO REG) fed with serial data from the core logic and from the output register.

12. A VLSI chip according to any previous claim, characterised by at least one signal registration means (MS1, MS2) fed with a signal (TST, TCE) from a pin and which passes the signal direct to one output (TST EARLY, TCE EARLY) and with clocking to another output (TST COPY, TCE COPY).

13. A VLSI chip according to claim 12, characterised in that the direct signal acts as a set up signal to predetermined flip-flops prior to their receiving the clocked signal.

14. A VLSI chip according to any previous claim, characterised by means (52, 53) separating a system clock input (CLKO) as a first clock signal (CLK1) to the control circuitry and a second clock signal (CLK2) to the input and output registers to allow the control register to operate without clocking the input or output registers.

# Check Sum Circuitry for VLSI Chip

This invention relates to random number generator input registers and check sum output register circuitry for VLSI chips.

It is often desirable, particularly in testing VLSI chips, to generate a sequence of pseudo-random numbers.  This can be done by means of a pseudo-random number generator comprising a shift register with a plurality of XOR feedback paths implementing a polynomial.  A "seed" input is initiated through the least significant bit of the register and propagating it through the entire register.

If such a register is large, its design presents various problems. The object of the present invention is to provide an improved pseudo-random number generator in which such problems are alleviated.

Problems also occur which corrupt or contaminate the test output, thus hiding errors in the core area logic under test.  Check sum circuitry using the output register alleviates these companion problems.

Accordingly, the present invention provides a shift register with a plurality of XOR feedback paths characterised in that the register is divided into a plurality of separable segments such that in each segment the feedback paths couple the final stage of the segment to a plurality of intermediate stages of the same segment.

Preferably, the registers have co-prime periods; the number of feedback paths of each register segment is an even integer approximately equal to either one third or two thirds of the number of stages in the register segment; the register segments are all of different lengths, the first being the longest; and the feedback

pattern of each register segment is a maximum length polynomial.

The features of the present patent application find particular application in combination with several other features concerned with a VLSI chip in which implementation and testing of the desired functions can be readily achieved. Three further patent applications of the same applicants are being filed simultaneously herewith, "VLSI Chip with Test Circuitry" (Appendix A), "Clock Distribution on VLSI Chip" (Appendix B) and "VLSI chip with Ring Oscillator" (Appendix C). These are directed primarily to related features of a VLSI chip; their descriptions are hereby incorporated in the present patent application by reference. All of the components of the general system work together to provide improved performance, enhanced flexibility, and added features.

Among the features of the general system described in those applications are: a ring oscillator distributed around the periphery of the chip for measuring performance characteristics; a unit I/O cell design connected to each signal pin and located around the periphery from which are built the serially connected input register (IR) and output register (OR); extra register flip-flops (some of which are "dummy" or "filler" flip-flops for increasing the length of a register, and some of which are Control Register flip-flops) provided in a serial path; the input register and output register being serially linked and forming a boundary scan test structure; clock signals being provided to the IR and/or OR to de-couple them from the control register's clock; Test Strobe (TST) and Test Clock Enable (TCE) inputs to the chip being provided in latched and early forms for enhanced functionality; means for measuring clock skew

from within the user customisable central logic area (also called the core logic area; and the use of a control register to control on-chip test and maintenance functions. These features, concerned with testability, are primarily located around the periphery of the chip; the core area of the chip is used for the ASIC (Application Specific Integrated Circuit) portion of the chip, and consists generally of a large number of flip-flops interconnected by combinatorial circuits to perform some desired function.

These features of the chip are useful not merely to enhance testability but to do so in such a way that a limited amount of silicon real estate is employed. The design of such chips is made easier by ensuring that the testability is taken care of, in a manner which is unchanging from one ASIC to another, before user customisable design is begun. The features concerned with testing are generally located around the periphery of the chip, and the ASIC is located in the central or core logic area of the chip. The design and features of the logic in the ASIC portion are subject to change at the whim of the designer, and such changes are not related to the present invention.

The present generator finds particular application in such a chip.

Accordingly the present invention also provides a VLSI chip including a core logic area performing an operational function and an input register configurable as pseudo-random number generator for applying a test pattern to the core logic. The logic features of the core logic will be subjected to the test pattern as generated by the input register.

The chip may also contain an output register for receiving test data output through the core logic in

response to the test patterns, characterised in that the check sum output register has only a small number of its stages outputs XORed to provide input to the first stage of said output register.

The chip may have a large number of I/O cells around its periphery which normally operate as input and output to the core logic of the chip and are also operable as test circuitry, some of said cells being configurable to form the pseudo-random number generator and, if present, the check sum output register. The configuring may be partly with I/O cells and partly with dummy cells.

A pseudo-random number generator and a check sum output register in accordance with the invention will now be described, by way of example, with reference to the drawings, in which:

Figure 1 is a logic diagram of the output register of the chip;

Figure 2 is a logic diagram of a prior design for an input register; and

Figure 3 is a logic diagram of the input register of the chip.

OPERAND GENERATION SCHEME FOR THE INPUT REGISTER

The chip itself is described in the above-mentioned patent application, "VLSI Chip with Test Circuitry". Briefly, the chip is provided with a large number of I/O cells around its periphery. Each such cell is operable to pass a signal from an associated pin to the core area of the chip or vice versa. The I/O cells also include flip-flops which are serially connected through the cells to form registers, and in particular an input register (IR) and an output register (OR). A control register (CR) controls the functioning of the cells. There may also be dummy I/O cells having

no associated pins.

The chip can be operated in various test modes, under the control of the control register. In particular, there is a test mode in which the input register generates a pseudo-random number sequence which is applied to the ASIC in the core logic area, and the output from that area is received by the output register, which operates to accumulate that output in a check sum generating manner.

To test the chip in this mode, a sequence of pseudo-random numbers must be generated in the input register by initiating a "seed" input through the least significant bit of the register and propagating it through the entire register. The seed is propagated through the chain of registers (CR-IR-OR or IR-OR). After loading, the Input Register will generate a new pseudo-random input to the core logic on each subsequent clock (the chip being set in pseudo-random generator mode). Thus, the input register creates input operands for pushing into and through the logic of the chip to test that logic for faults.

To detect certain faults, called sequential faults, signal independence of serially adjacent bits is required. For instance, if the input operand at some location has two serially connected bits which are 00 on some clock cycle, on the next clock cycle the second bit will always be 0, though the first could be 1 or 0. Thus, on a given clock cycle, the second bit is dependent on the first bit from the previous clock cycle. So, for example, the sequential patterns of 00 followed on the next clock by 01 or 11 are impossible. Similar sequential dependence can be found between bits with one intervening bit, with sequential dependency occurring every two clock cycles. In general, such

sequential dependency can be found for flip-flops n bits apart at every nth clock cycle. Without independence between adjacent bits, certain sequential faults cannot be detected.

It is known to feed back the most significant bit and some sub-set of the input register bit outputs to bit 0 (the least significant or first bit) through an XOR (exclusive OR gate) tree. The larger the number of such feedbacks, the more gate delay time it takes to push them through the XOR tree. Since the operand created by the input register would only be serially independent at bit 0, there is a high probability that needed sequential patterns (such as 00 followed by 01 or 11) will not be capable of being generated. In the present system, four serially connected flip-flop outputs are fed back to approximately one third of the other flip-flops.

Figure 3 shows the preferred arrangement. The input register 9 is broken up into four segments 9a, 9b, 9c and 9d. Each segment has calculated for it a maximum length polynomial which generates a maximum sequence before repetition of $2^n-1$, where n is the length of the segment. The polynomial is implemented by feedbacks through the XOR gates as indicated. The preferred arrangement has 249 input register bits, broken into segments of lengths 67, 63, 64 and 55 in order, and the polynomials are (in hexadecimal)

9,48D0,BB21,1442,3701 for segment 9a;

C41C,4509,8E22,1221 for segment 9b;

1,4594,4488,B121,2351 for segment 9c; and

94,4093,424A,4945 for segment 9d.

Taking the first segment, the polynomial starts, in binary, 1001,0100,1000,1101,..., and the feedback from the most significant bit of this segment goes to the "1"

bits in this polynomial, i.e. to bits 0, 3, 5, 8, 12, 13, 15, etc. (Feedback to a particular bit means that the input to that bit is the output from the most significant bit XORed with the output of the preceding bit, except in the case of bit 0, which can be XORed with Test Data Input or any other consistent signal as desired by the designer). In general, by feeding back to one third of the flip-flops in each segment, approximately one third of the adjacent (or one bit/cycle sequential dependencies), and a much greater proportion of higher dependencies, will be broken up. (If two thirds is used, the same effect is felt, because of re-alignment of dependencies). Of course, if the optimal exact one third is not achievable, an approximate one third is used.

This division of the input register into four segments has various advantages. It is much easier to find factors of the quantities $2^n-1$ for the four segments individually than for the whole register. The register extends around all four sides of the chip, and the four segments are preferably located more or less one along each edge; this makes the feedback routing easier to lay out. Also, the loading on the source of the feedback signals is split between the four segments instead of all falling on a single final register stage.

Any number of segments of suitable lengths using maximum length polynomials to describe the feedback could be used; but the values of $2^n-1$ for the different segments should all be coprime (in pairs). Techniques for generating such polynomials are common knowledge in ECC (error correcting code) theory. Dummy bits are added as necessary to the input register to make the requirements for operand generation stated above feasible. These could be formed as serial shift

register elements unconnected to pins as in the preferred arrangement. It is also preferred to have the largest segment first to obtain maximum sequential randomness.

It is known from ECC theory that by feeding an operand through certain polynomials, a maximum sequence of $2^n-1$ non-repeated value states can be achieved for an n bit register. It was previously known from ECC theory that such feedbacks to either one third or two thirds of the bits in the shift register resulted in a pseudo-random generator having maximal sequential entropy (randomness).

Figure 2 illustrates the old design, which has an XOR tree fed with an input h. A number of outputs from the bits of register 9 are fed back through lines a to e into this XOR tree, which XORs these outputs to produce a randomised output to be fed back to the least significant bit, bit 0, of input register 9. An expanded version of the XOR tree is shown in the blown-up portion of Figure 2 as being composed of five serially connected XOR gates g1 to g5. (In practice, there will normally be many more than five XOR gates in the tree.)

Since there is no large XOR tree in the present system, all XOR operations occur in the minimum gate delay time (within one gate delay). This speeds up the maximum rate at which the input register can be clocked, thus increasing test operation speeds.

**CHECK SUM GENERATION SCHEME FOR THE OUTPUT REGISTER**

An output register is used to hold the output of the chip logic elements under test (the core logic) immediately before providing output to be analysed. When outputs from several cycles are merged via a logical operation (such as parallel XORing, addition, subtraction or other mathematical operation), the

process is known as check-sum generation. In the present system, the output register is implemented as a serial shift ring (i.e. the most significant bit is fed back to the least significant bit with the output of each cycle XORed with the check-sum of the previous cycle shifted one bit toward the most significant bit). If a bit in the output register becomes corrupted by an error in the logic or for some other cause within the chip, that bit will remain corrupted for many clock cycles as it is shifted through the output register. However, there is a possibility that another error will flip a corrupted bit to incorrectly form what appears to be an uncorrupted output signature. This is known as aliasing. (Another aliasing problem occurs when the error is looped back and recurs at the same location, when it is returned there by the serial shift loop).

In prior designs, this problem has been reduced by using the entire output register as a cyclic redundancy check generator, using a huge XOR tree (similar to that of Figure 2 for the input register). Here, of course, we are talking about the output register, which is a linear serially shifted register.

Figure 1 shows the preferred arrangement in diagram form. To avoid aliasing of the check-sum value in the output register, bits 2 and 11 of the output register are fed back as inputs to bit 0 through an XOR tree to perform a cyclic redundancy check operation. Thus bits 0, 2, 11 and the bits in between form a 12 bit cyclic redundancy check generator as a segment of the output register. The most significant bit is also fed back through the XOR tree to bit 0 to make the whole output register a ring. The output register 8 consists of three parts 8a, 8b, and 8c; the first part has register bits 0 to 2; the second part has bits 3 to 11;

and the third part has the bits from bit 12 to the most significant bit.

The present arrangement is based on the realization that only a small section of the output register is needed to perform the cyclic redundancy check (bits 0 - 11) or be implemented as a linear feed-back shift register. This means that only two bits of feedback need be used. The most significant bit is also fed back to form the cyclic ring.

In a test operation, the output register is cycled numerous times before the test data in it is read out, as a data test signature. It takes numerous clock cycles to get needed test data patterns through all the testable logic in the chip. The occurrence of an aliasing problem during the first cycle will not be discoverable with the present arrangement. Nevertheless, the inclusion of this type of redundancy check generator will greatly reduce the loop-back form of aliasing and reduce the chance of re-corruption of same bit to hide a bad signature anywhere it may occur, especially after the first cycle. Because the corrupted bit is subject to the XORed feedback, the error is multiplied throughout the test data signature.

*Fig. 3*

*Fig. 2*

*Fig. 1*

## VLSI CHIP WITH RING OSCILLATOR

This invention relates to improvements in VLSI (very large scale integration) testability and standardised chip design.

As the number of gates in a VLSI chip goes up and as they become more and more application-specific in design, the need for simple, consistent testability characteristics becomes more and more important.   Along with testing for the correctness of logic, process characteristics which affect performance (such as variations in capacitance and resistance) can and should also be tested for.

The general object of the present invention is therefore to provide a VLSI chip in which implementation and testing of the desired functions can be achieved more readily.

The invention is primarily concerned with the provision, on a VLSI chip, of a ring oscillator, consisting of a ring of inverters.   The performance of such a ring oscillator gives an indication of the chip performance.   Known ring oscillators have, however, various defects in their performance, and a specific object of the present invention is to provide an improved ring oscillator of improved performance.

Accordingly therefore the present invention provides a VLSI chip including a ring oscillator in the form of a loop on the peripheral area of the chip encircling the core logic area, characterised in that it has an inverting initiation gate fed from an input pin and an output stage feeding an output pin other than the input pin.

The output pin is preferably remote from the initiation gate;   the ring oscillator preferably has

loading conductors connected to it, and the size of the inverters of the ring oscillator preferably matches the size of similar logic elements in the core logic area.

Preferably also substantially all normal (operational) signals to and from the core logic area are coupled to the chip pins by means of input/output cells located in the peripheral area of the chip.

The present patent application is primarily directed to only some of the features of a general system. Three further patent applications of the same applicants are being filed simultaneously herewith, "VLSI Chip with Test Circuitry" (Appendix A), "Check Sum Circuitry for VLSI Chip" (Appendix B), and "Clock Distribution on VLSI Chip" (Appendix C). These are directed primarily to the remaining features of the system; their descriptions are hereby incorporated in the present patent application by reference.

All of the components of the general system work together to provide improved performance, enhanced flexibility, and added features. Among the features of the general system described in those applications are: a unit I/O cell design connected to each signal pin and located around the periphery from which are built the serially connected input register (IR) and output register (OR); xtra register flip-flops (some of which are "dummy" or "filler" flip-flops for increasing the length of a register, and some of which are Control Register flip-flops) are provided in a serial path; the input register and output register being serially linked and forming a boundary scan test structure; clock signals being provided to the IR and/or OR to de-couple them from the control register's clock; Test Strobe (TST) and Test Clock Enable (TCE) inputs to the chip being provided in latched and early forms for enhanced

functionality; an optimised operand generation scheme for the input register; a new check-sum generation scheme for the output register; the use of a control register to control on-chip test and maintenance functions; and the clock distribution arrangements. These features, concerned with testability, are primarily located around the periphery of the chip; the core area of the chip is used for the ASIC (Application Specific Integrated Circuit) portion of the chip, and consists generally of a large number of flip-flops interconnected by combinatorial circuits to perform some desired function. The design and features of the logic in the ASIC portion are subject to change at the whim of the chip designer, and such changes are not related to the subject of this patent.

The features of the general arrangement are useful not merely to enhance testability but to do so in such a way that a limited amount of silicon real estate is employed. The design of such chips is made easier by ensuring that the testability is taken care of, in a manner which is unchanging from one ASIC to another, before user customisable design is begun.

A VLSI chip incorporating the various features of the present arrangement will now be described, by way of example, with reference to the drawings, in which the sole Figure is a logic diagram illustrating the organisation of the ring oscillator of the chip.

The Figure shows the ring oscillator circuit of the present arrangement. The circuit 40 is stretched around the periphery of the VLSI chip CHIP so that manufacturing process variations which occur across the surface of the chip will be averaged out. For simplicity the ring oscillator circuit 40 is only partially illustrated, to show only the relevant

features; in practice, it will consist of hundreds of identical inverters. The circuit requires an odd number of gates or inverters, and the initiation pulse comes from a pin P which provides a Ring Oscillator Enable signal ROE. The initiation pulse starts the oscillation and the rate is measured. The variation in oscillation rate from the nominal or design value provides a measurement of the quality of the manufacturing process across the entire chip surface. This measurement is a predictor of actual chip performance.

Previous designs for ring oscillators have used elements of a different size from the elements used in the core area, which made their measurements of limited usefulness. To get best results, the transistors used in the ring oscillator elements should be of the same size as those used in the core area. The present ring oscillator circuit provides a better means for measuring chip performance than was previously available.

The initialisation input ROE to a NAND gate 42 provides the initial pulse to start the circuit in motion. An odd number of inverters (even number plus the NAND gate 42) cause the circuit to oscillate continuously. The rate of oscillation can be monitored at the output pin closest to the inverter used for monitoring it. In this case, inverter 44 provides the ring oscillator output ROO at pin P. A different inverted output (including the NAND gate) could be used, but in the preferred arrangement, a particular gate close to a particular pin is chosen for all ASIC variations.

To improve accuracy of this ring oscillator, an additional set of metal lines which add parasitic capacitance to the ring is added to the circuit to increase its loading. This better approximates the conditions in

the core of the chip, where more loading is usually present. These lines are simply strips or pieces of metal, polysilicon or other conductive material 46 with no connection to other circuits on the chip.

## CLOCK DISTRIBUTION ON VLSI CHIP

This invention relates to improvements in VLSI (very large scale integration) testability and standardised chip design.

As the number of gates in a VLSI chip goes up and as they become more and more application-specific in design, the need for simple, consistent testability characteristics becomes more and more important.  Along with testing for the correctness of logic, process characteristics which affect performance (such as variations in capacitance and resistance) can and should also be tested for.

The general object of the present invention is therefore to provide a VLSI chip in which implementation and testing of the desired functions can be achieved more readily.

The invention is primarily concerned with monitoring the clock skew which results when the different chips in a module or circuit board impose widely varying loadings on a common clock signal.  In order to design co-ordinated circuits, measurement of clock skew must be available.  Also, to ensure the proper functioning of the circuits in a card or module, the clock skew must fit within a certain range of variability, and this must be testable.  Clock skew has hitherto been measured by taking a signal from the clock input pin to the chip.

Accordingly the present invention provides a VLSI chip having an internally located system clock bus for distributing clock signals, and pin means for feeding clock signals to the bus and monitoring those signals, characterised in that the pin means comprise two pins connected to separated positions on the clock bus, one pin being used to supply clock signals to the chip and

the other being used to monitor those signals.

Preferably the chip has a core logic area generally in its interior, the system clock bus being located in the core logic area.

Preferably also substantially all normal (operational) signals to and from the core logic area are coupled to the chip pins by means of input/output cells located in the peripheral area of the chip.

The present patent application is primarily directed to only some of the features of a general system. Three further patent applications of the same applicants are being filed simultaneously herewith, "VLSI Chip with Test Circuitry" (Appendix A), "Check Sum Circuitry for VLSI Chip" (Appendix B), and "VLSI Chip with Ring Oscillator" (Appendix C). These are directed primarily to the remaining features of the system; their descriptions are hereby incorporated in the present patent application by reference.

All of the components of the general system work together to provide improved performance, enhanced flexibility, and added features. Among the features of the general system described in those applications are: a unit I/O cell design connected to each signal pin and located around the periphery from which are built the serially connected input register (IR) and output register (OR); extra register flip-flops (some of which are "dummy" or "filler" flip-flops for increasing the length of a register, and some of which are Control Register flip-flops) are provided in a serial path; the input register and output register being serially linked and forming a boundary scan test structure; clock signals being provided to the IR and/or OR to de-couple them from the control register's clock; Test Strobe (TST) and Test Clock Enable (TCE) inputs to the chip

being provided in latched and early forms for enhanced functionality; an optimised operand generation scheme for the input register; a new check-sum generation scheme for the output register;the use of a control register to control on-chip test and maintenance functions; and an improved ring oscillator. These features, concerned with testability, are primarily located around the periphery of the chip; the core area of the chip is used for the ASIC (Application Specific Integrated Circuit) portion of the chip, and consists generally of a large number of flip-flops interconnected by combinatorial circuits to perform some desired function. The design and features of the logic in the ASIC portion are subject to change at the whim of the designer, and such changes are not related to the present invention.

The features of the general arrangement are useful not merely to enhance testability but to do so in such a way that a limited amount of silicon real estate is employed. The design of such chips is made easier by ensuring that the testability is taken care of, in a manner which is unchanging from one ASIC to another, before user customisable design is begun.

A VLSI chip incorporating the various features of the present arrangement will now be described, by way of example, with reference to the drawings, in which the sole Figure is a logic diagram illustrating the organisation of the clock monitoring and distribution arrangements of the chip.

The invention is primarily concerned with monitoring the clock skew which results when the different chips in a module or circuit board impose widely varying loadings on a common clock signal. In order to design co-ordinated circuits, measurement of

clock skew must be available. Also, to ensure the proper functioning of the circuits in a card or module, the clock skew must fit within a certain range of variability, and this must be testable. Clock skew has hitherto been measured by taking a signal from the clock input pin to the chip.

Ordinarily, all the chips in a module or circuit board are fed from a single clock at the same time, either from a single fan out point or from multiple fan out points on that module or card. Where large variations are present between the amount of loading in the different chips in a module or card, the clock skew produced by the clock pulse travelling through the card can be significantly different from chip to chip on the same module. The known method of measuring clock skew involves taking a signal from the clock input pin to the chip, which monitors the clock signal before it enters the chip and fails to monitor signal skew occurring in the interior of the chip.

In the present arrangement, a special clock monitoring pin is dedicated to the task and allows measurement of single chip clock delay as well as the variation in skew between chip clock monitor outputs. The system clock input is wired to the clock fan out bus and this bus is tied not only to the core logic deep within the chip but also to the dedicated clock monitoring pin. Thus, the loading of the circuit affects the skew monitor directly.

Referring to the Figure, pin P3 receives clock input CLK0 which provides clock pulses to the clock bus CLB. Clock skew is measured at pin P4, which is connected to the clock bus CLB by line 49. This gives an accurate measure of the skew caused by loading in the core logic area which receives the signal CLK0.

Fig. 1

Fig. 2

EP 0 313 230 A2

Fig. 3

EP 0 313 230 A2